# EUROPEAN PATENT SPECIFICATION

(11) **EP 3 414 357 B1**
(45) Date of publication and mention of the grant of the patent: **17.06.2020**
(21) Application number: 17749921.7
(22) Date of filing: 06.02.2017
(51) Int. Cl.: C23C 16/455, C23C 16/507, H01L 21/02, C23C 16/44, H01J 37/32, C23C 16/458, C23C 16/505

(54) **AN APPARATUS FOR ATOMIC LAYER DEPOSITION**
VORRICHTUNG ZUR ATOMLAGENABSCHEIDUNG
APPAREIL DE DÉPÔT DE COUCHE ATOMIQUE

(30) Priority: 10.02.2016 FI 20165099
(43) Date of publication of application: 19.12.2018
(73) Proprietor: Beneq OY, 02200 Espoo (FI)
(72) Inventor: SOININEN, Pekka, 02200 Espoo (FI); SÖDERLUND, Mikko, 02200 Espoo (FI); TIMONEN, Paavo, 02200 Espoo (FI)
(74) Representative: FRKelly
(86) International application number: PCT/FI2017/050064
(87) International publication number: WO 2017/137660

(56) References cited:
- WO-A2-2008/028082
- JP-A- 2012 177 173
- JP-A- 2012 177 173
- US-A1- 2005 252 449
- US-A1- 2009 126 634
- US-A1- 2009 250 443

## Description

### FIELD OF THE INVENTION

The invention relates to an apparatus for subjecting a surface of a substrate to surface reactions of at least a first precursor and a second precursor according to the principles of atomic layer deposition, and more particularly to an apparatus as defined in the preamble of the independent claim 1.

### BACKGROUND OF THE INVENTION

Atomic layer deposition (ALD) is conventionally carried out in a reaction chamber under vacuum conditions. One or more substrates are first loaded into the reaction chamber and then vacuum is evacuated into the reaction chamber and the reaction space inside the reaction chamber is heated to process temperature. The atomic layer deposition is then carried out by supplying at least first and second gaseous precursors into the reaction chamber alternatingly and repeatedly for providing a coating layer with desired thickness on the surface of the substrate. A full ALD cycle, in which the first and second precursor are supplied into the reaction chamber comprises: supplying a pulse of first precursor into the reaction chamber, purging the first precursor from the reaction chamber, supplying a pulse of second precursor into the reaction chamber and purging the second precursor from the reaction chamber. Purging precursors may comprise discharging the precursor material from the reaction chamber, supplying purge gas, such as nitrogen, into the reaction chamber and discharging the purge gas. When desired number of ALD cycles and thus a desired coating layer thickness is reached, the vacuum in the reaction chamber is vented and the substrates are unloaded from the reaction chamber. Then the same process is repeated for the next substrates.

ALD coating can be modified by applying plasma to the deposition cycle, this is called plasma-enhanced ALD. The plasma may be capacitively coupled such that two electrodes are placed within a small distance from each other, one of the electrodes is connected to an RF power supply and the other is grounded. RF power is coupled to electrodes in the process chamber to generate ions and/or radicals and reactive atoms. The plasma may also be coupled inductively or through ECR coupling.

One problem arising typically in an ALD process is that during the ALD process along coating the surface of a substrate with the precursors other surfaces of the reaction chamber are coated as well. In order to maintain good quality in the process surfaces of the reaction chamber have to be cleaned at intervals. When an ALD apparatus is part of a cluster tool cleaning of the apparatus becomes a very important issue because it affects to other process tools connected to the cluster as well. Normally the reaction chamber is opened and the surfaces can then be cleaned or parts can be taken away and cleaned outside the reaction chamber but for that at the same time the vacuum is vented and it has to be evacuated before a next ALD processing can be started. Evacuating vacuum and venting it as well heating the reaction space takes significant amount of time and during that the process module cannot be operated and other process tools connected to the cluster cannot be used or can be used with limited operation.

The cluster tool means that there is a plurality of process tools connected to each other such that the substrates can be moved between different vacuum chambers located close to each other. The cluster tool usually operates together with a cluster tool robot. The problems in a plasma-ALD apparatus relate also to the above mentioned contamination and that the coating process should be able to continue without interruptions relating to the cleaning of the apparatus which results from a demand that the coating process should be effective.

JP2012177173A discloses a thin film deposition apparatus for depositing a thin film on a substrate and includes a film deposition vessel having a film deposition space for depositing the thin film on the substrate in a vacuum state, a gas introducing part for introducing gas to be used for thin film deposition into the film deposition space of the film deposition vessel, and a plasma electrode part for generating plasma by using the gas in the film deposition space. The plasma electrode part includes a rectangular plasma generating electrode plate in which the current flows from one end face to the other end face, and a principal surface is directed to the film deposition space, and a pair of magnets which are juxtaposed along a side surface of the electrode plate so as to hold the electrode plate from both side surfaces and of which the ends directed to the film deposition space have polarities different from each other.

### BRIEF DESCRIPTION OF THE INVENTION

The present disclosure provides an apparatus for subjecting a surface of a substrate to surface reactions of at least a first precursor and a second precursor according to the principles of atomic layer deposition, as detailed in claim 1. Advantageous features are provided in dependent claims.

An object of the present invention is to provide an apparatus so as to alleviate the above disadvantages. The objects of the invention are achieved by an apparatus which is characterized by what is stated in the independent claim. The preferred embodiments of the invention are disclosed in the dependent claims.

An apparatus according to the invention is for subjecting a surface of a substrate to surface reactions of at least a first precursor and a second precursor according to the principles of atomic layer deposition. The apparatus comprises a reaction chamber forming a reaction space for receiving precursor gases reacting on the surface of the substrate. The apparatus further comprises a substrate support for holding the substrate; a dielectric plate; and an electrode coupled to a voltage source to induce voltage to the electrode for generating electric discharge to the reaction space. The dielectric plate is arranged between the substrate support and the electrode and such that the reaction space is arranged between the substrate support and the dielectric plate.

The reaction chamber is formed from surfaces connected to each other such that there is a bottom surface, a top surface and at least one side surface between the top surface and the bottom surface and the dielectric plate forms at least part of one of the surfaces forming the reaction chamber.

In a preferred embodiment of the invention the reaction chamber is formed from a top surface being at least partly made from a dielectric plate, such as glass, quartz or glass-ceramic, and a bottom surface being a substrate support. The substrate support is preferably movable in a vertical direction such that the substrate support closes the reaction chamber and such that the reaction chamber can be loaded from the bottom side. The at least one side surface is in a preferred embodiment of the invention side walls surrounding the reaction space and connected to the top surface and to the bottom surface. The connection between the top surface and/or the bottom surface may be openable for example in the case where the bottom surface is movable in vertical direction the side surfaces can move together with the bottom surface and the top surface can maintain its position or the side surfaces may remain on their place while the bottom surface moves. In another embodiment of the invention the bottom surface, the side surface and the top surface are all movable in vertical direction either alone or together or in a combination of that. In one embodiment of the invention the top surface and the side surfaces are made as one piece and the bottom surface, which is a susceptor plate moves for opening and closing the chamber.

In another embodiment of the invention the reaction chamber is formed such that the top surface is the substrate support and the bottom surface is formed at least partly from the dielectric plate. In that case the top surface is preferably either movable in vertical direction or some other way openable so that substrates can be loaded and unloaded to the substrate support.

In other words the reaction chamber is defined at least partly from one side of the reaction chamber by the dielectric plate. The dielectric plate is such that when the RF power is coupled to the electrode arranged on one side of the dielectric plate ions and reactive atoms are generated to the other side of the dielectric plate for generating plasma together with precursors supplied into the reaction space. The substrate support serves as the other electrode which is grounded. The dielectric plate is preferably made from glass or ceramic or a combination of glass and ceramic.

An advantage of the apparatus according to the invention is that residue from the coating process stays in the reaction chamber and the apparatus itself stays clean. Another advantage is that when the electrode is arranged outside the reaction space the RF signal can be coupled to the electrode with a robot. Without the dielectric plate the electrode gets residue on its surface and removing it from the apparatus is difficult. The dielectric plate acts as a sacrificial protector and is also an insulant but still transmits the RF signal. This way the electrode can operate normally and still be protected. The dielectric plate can easily be removed and cleaned and then put back again or replaced with a new one.

### BRIEF DESCRIPTION OF THE DRAWINGS

In the following the invention will be described in greater detail by means of preferred embodiments with reference to the attached drawings, in which
Figure 1 shows an embodiment of the apparatus according to the invention in a process position;
Figure 2 shows an embodiment of the apparatus according to the invention in a loading position;
Figure 3 shows another embodiment of the apparatus according to the invention in a process position; and
Figure 4 shows the embodiment of the apparatus shown in figure 3 in a loading position.

### DETAILED DESCRIPTION OF THE INVENTION

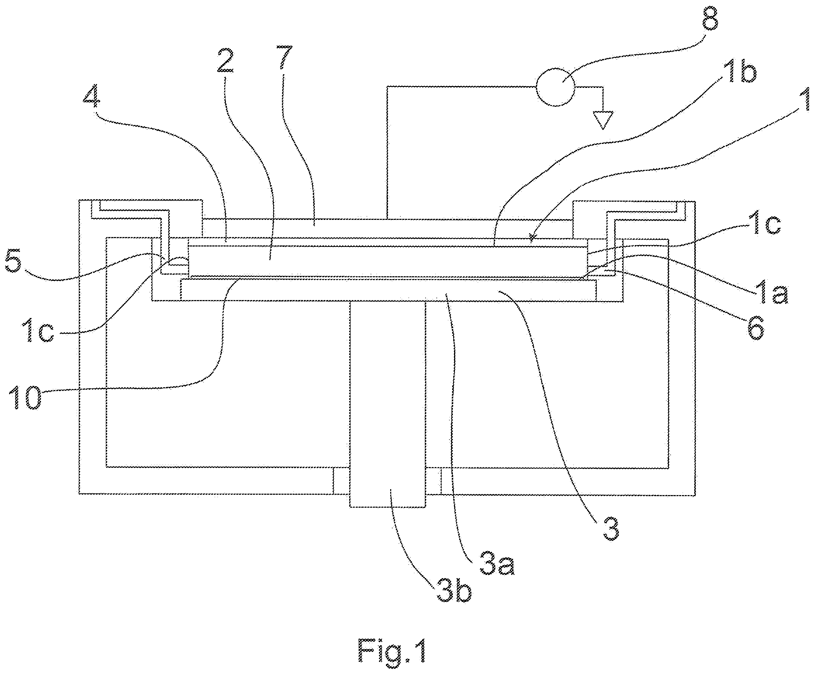

Figure 1 shows an embodiment of the invention in which the reaction chamber 1 is closed, i.e. in a process position. The reaction chamber 1 forms the outline for the reaction space 2 in which surface reactions of at least a first precursor and a second precursor according to the principles of atomic layer deposition are subjected to a substrate 10. In this embodiment of the invention the reaction chamber 1 comprises a substrate support 3 as the bottom surface 1a of the reaction chamber 1 and a dielectric plate 4 as the top surface 1b of the reaction chamber 1. Although the figure shows that the dielectric plate 4 forms the entire top surface 1b of the reaction chamber 1, it may alternatively form only part of the top surface 1b. The electrode 7 is arranged in an operational connection with the dielectric plate 4 for generating electric discharge through the dielectric plate 4 to the reaction space 2 for generating plasma together with precursors supplied into the reaction space 2. The precursors are supplied in this embodiment of the invention from one side surface 1c of the reaction chamber 1 and discharged from the opposite side surface 1c. The apparatus comprises at least one precursor feeding channel 5 for supplying precursor to the reaction space 2 and at least one discharge channel 6 for discharging precursor from the reaction space 2. As shown in figure 1 the feeding channel 5 and the discharge channel 6 are arranged such that the output face of the channels 5, 6 are on the side surfaces 1c of the reaction chamber 1. In another embodiment of the invention the precursor feeding channel 5 and the discharge channel 6 may be arranged to extend such that the output face of the precursor feeding channel 5 is arranged to the top surface 1b of the reaction chamber 1 and the output face of the discharge channel may be arranged on both of the side surfaces of the reaction chamber 1 or to the other side surface of the reaction chamber 1 or such that the precursors are discharged from the side surfaces of the reaction chamber 1 and further pumped under the bottom surface 1a outside of the reaction chamber 1. The electrode 7 is arranged outside the reaction chamber 1 and coupled to a voltage source 8 to induce voltage to the electrode 7 for generating electric discharge to the reaction space 2 for creating plasma together with precursors. The voltage source 8 may be arranged further away from the electrode 7 or it may be close to the electrode 7. As the electrode 7 is arranged outside the reaction chamber 1 also the electrode match is arranged outside the reaction chamber 1. In other words the reaction chamber 1 is formed from a bottom surface 1a, a top surface 1b and at least one side surface 1c for forming a reaction space 2 in which the surface reactions of a substrate 10 are arranged to happen. The electrode 7 is arranged outside of the reaction space 2 such that between the electrode 7 and the reaction space 2 is a dielectric plate 4. The electrode 7 is coupled to a voltage source which is preferably an RF-generator.

The substrate support 3 preferably comprises a movable susceptor having a support part 3a for supporting the substrate and a pedestal part 3b for moving the substrate between the process position and the loading position. The movement of the pedestal part 3b is preferably vertical. In other words the substrate support 3 can be moved to unload the processed substrate and to reload a new substrate.

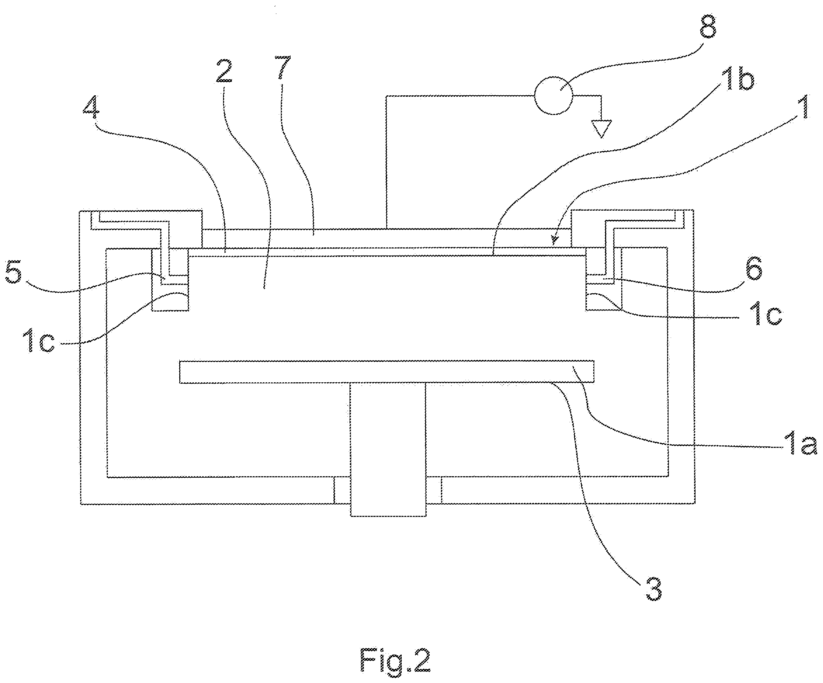

Figure 2 shows the reaction chamber 1 in an open state, i.e. in a loading position. In this figure the substrate 10 to be processed will be loaded to the substrate support 3 when the pedestal part 3b has moved together with the support part 3b such that the reaction chamber 1 is open and there is space to load the substrate 10 to the substrate support 3. The dielectric plate 4 forms at least part of the top surface 1b of the reaction chamber 1. The dielectric plate 4 can be arranged as a fixed part of the apparatus or alternatively as a removable part of the apparatus. When being arranged as a removable part the dielectric plate 4 is arranged such that it can be taken from the apparatus for cleaning purposes or other maintenance and then put back again without disassembling the whole apparatus or most of the apparatus but for example by loosening the connection between the dielectric plate 4 and the structure surrounding the dielectric plate 4.

In another embodiment of the apparatus the dielectric plate 4 is pressed against a structure surrounding the dielectric plate with the help of a movable support and the dielectric plate 4 can be moved together with the movable support for removal from the apparatus. In this embodiment of the invention the dielectric plate 4 forms at least part of the top surface 1b of the reaction chamber 1. Alternatively the dielectric plate 4 can be arranged to the bottom surface 1a of the reaction chamber 1 in which case the reaction chamber is preferably opened somewhere else than from the bottom surface 1a, for example from the top surface 1b. The dielectric plate 4 is preferably made of glass, but it can be from other dielectric material such as plastic.

In an embodiment of the invention in which the substrate support 3 is movable in a vertical direction for moving the substrate 1 between a process position in which the reaction chamber 1 is in a closed state and a loading position in which the reaction chamber 1 is in an open state the dielectric plate 4 is also made as movable part. The dielectric plate 4 can be movable together with the substrate support between the process position and the loading position or it may have an own support structure which is movable or alternatively if a mask frame is used in the coating process and has its own movable mask alignment supports then the dielectric plate 4 can move together with the mask alignment supports.

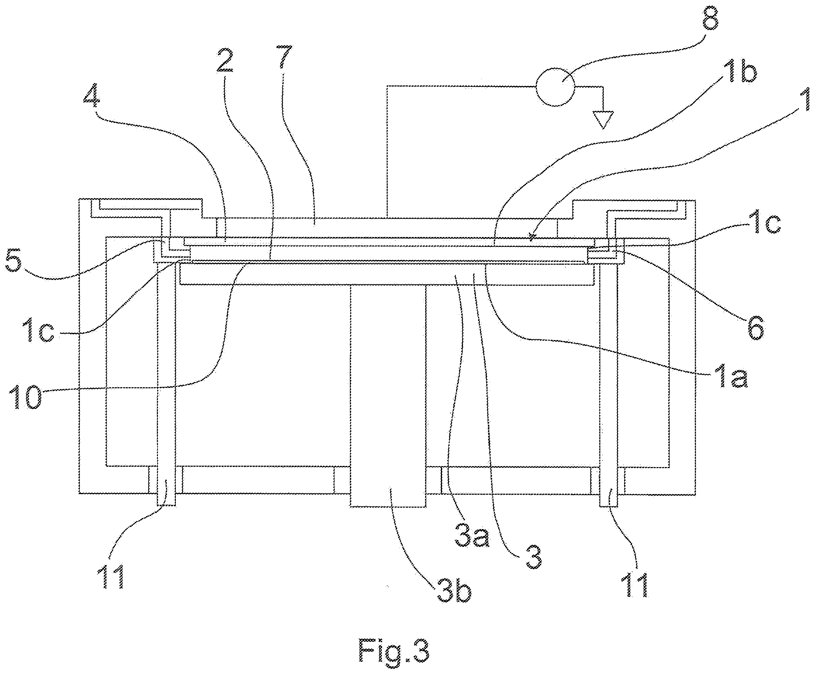

Figure 3 shows an embodiment of the invention in which the apparatus comprises lifters 11 for moving the dielectric plate 4 in a vertical direction for removing said dielectric plate 4 from the apparatus to be cleaned or replaced. In other words, the dielectric plate 4 is arranged removably to the apparatus such that it can be removed from the apparatus without disassembling the whole apparatus. The figure 3 shows the apparatus in a process position in which the reaction chamber 2 is closed so that the substrate 10 can be processed. In this embodiment the feeding channel 5 and the discharge channel 6 are arranged such that the output face of the channels 5, 6 are on the side surfaces 1c of the reaction chamber 1 and the dielectric plate 4 forms the top surface 1b of the reaction chamber 1. The bottom surface 1a of the reaction chamber 1 is formed with the substrate support 3 which comprises the support part 3a for supporting the substrate and the pedestal part 3b for moving the substrate between the process position and the loading position. The output face of the feeding channel 5 and the discharge channel 6 are arranged such that they are movable in vertical direction together with the dielectric plate 4. The movement of the dielectric plate 4 is arranged with lifters 11 supporting the output face part of the channels 5, 6.

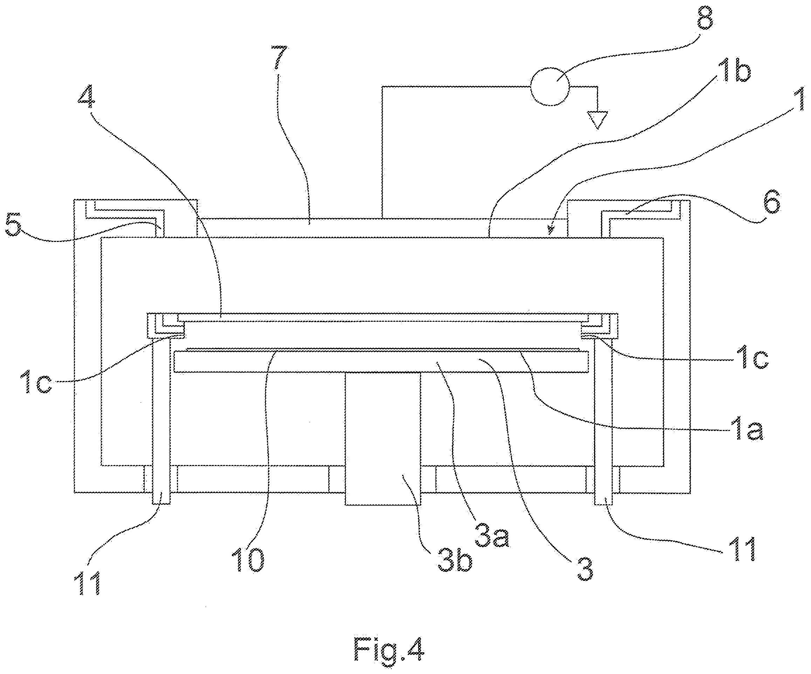

Figure 4 shows the apparatus shown in figure 3 in a loading position in which the pedestal 3b has moved the substrate 10 in the substrate support 3a downwards and the lifters 11 have moved part of the channels 5, 6 and the dielectric plate 4 downwards such that the dielectric plate 4 can be removed from the apparatus. This is just one example of how to remove the dielectric plate 4 from the apparatus.

## Claims

1. An apparatus for subjecting a surface of a substrate to surface reactions of at least a first precursor and a second precursor according to the principles of atomic layer deposition, said apparatus comprising
- a reaction chamber (1) forming a reaction space (2) for receiving precursor gases reacting on the surface of the substrate,
- a substrate support (3) for holding the substrate,
- a dielectric plate (4), wherein the dielectric plate (4) is arranged removably to the apparatus such that it can be removed from the apparatus without disassembling the whole apparatus, and
- an electrode (7) coupled to a voltage source (8) to induce voltage to the electrode (7) for generating electric discharge to the reaction space (2),
- the dielectric plate (4) being arranged between the substrate support (3) and the electrode (7) so that the reaction space (2) is arranged between the substrate support (3) and the dielectric plate (4), the substrate support (3) being movable in a vertical direction for moving the substrate (1) between a process position in which the reaction chamber (1) is in a closed state and a loading position in which the reaction chamber (1) is in an open state, **characterized in that** the dielectric plate (4) is movable together with the substrate support (3) between the process position and the loading position.

2. An apparatus according to claim 1, **characterized in that** the reaction chamber (1) is formed from surfaces connected to each other such that there is a bottom surface (1a), a top surface (1b) and at least one side surface (1c) and the dielectric plate (4) forms at least part of one of the surfaces (1a, 1b, 1c) forming the reaction chamber (1).

3. An apparatus according to claim 2, **characterized in that** the dielectric plate (4) forms at least part of the top surface (1b) of the reaction chamber (1).

4. An apparatus according to any previous claim, **characterized in that** the electrode (7) is arranged in an operational connection with the dielectric plate (4) for generating electric discharge through the dielectric plate (4) to the reaction space (2) for generating plasma together with precursors supplied into the reaction space (2).

5. An apparatus according to any previous claim, **characterized in that** the dielectric plate (4) is made of glass.

6. An apparatus according to any previous claim, **characterized in that** the electrode (7) is arranged outside of the reaction chamber (1).

7. An apparatus according to any previous claim, **characterized in that** the apparatus further comprises at least one precursor feeding channel (5) for supplying precursor to the reaction space (2) and at least one discharge channel (6) for discharging precursor from the reaction space (2).

8. An apparatus according to claim 7, **characterized in that** the at least one precursor feeding channel (5) and the at least one discharge channel (6) are provided to the side surface (1c).

## Patentansprüche

1. Vorrichtung zum Unterziehen einer Oberfläche eines Substrats Oberflächenreaktionen mindestens eines ersten Precursors und eines zweiten Precursors gemäß den Grundsätzen der Atomlagenabscheidung, wobei die Vorrichtung Folgendes umfasst
- eine Reaktionskammer (1), die einen Reaktionsraum (2) zum Aufnehmen von Precursor-Gasen, die an der Oberfläche des Substrats reagieren,
- einen Substratträger (3) zum Halten des Substrats,
- eine dielektrische Platte (4), wobei die dielektrische Platte (4) entfernbar an der Vorrichtung derart angeordnet ist, dass sie von der Vorrichtung entfernt werden kann, ohne dass die gesamte Vorrichtung auseinandergenommen werden muss, und
- eine Elektrode (7), die an eine Spannungsquelle (8) gekoppelt ist, um Spannung zu der Elektrode (7) zum Erzeugen einer elektrischen Entladung in den Reaktionsraum (2) zu induzieren,
- wobei die dielektrische Platte (4) zwischen dem Substratträger (3) und der Elektrode (7) derart angeordnet ist, dass der Reaktionsraum (2) zwischen dem Substratträger (3) und der dielektrischen Platte (4) angeordnet ist, wobei der Substratträger (3) in einer vertikalen Richtung zum Bewegen des Substrats (1) zwischen einer Prozessposition, in der sich die Reaktionskammer (1) in einem geschlossenen Zustand befindet, und einer Ladeposition, in der sich die Reaktionskammer (1) in einem offenen Zustand befindet, beweglich ist, **dadurch gekennzeichnet, dass** die dielektrische Platte (4) zusammen mit dem Substratträger (3) zwischen der Prozessposition und der Ladeposition beweglich ist.

2. Vorrichtung nach Anspruch 1, **dadurch gekennzeichnet, dass** die Reaktionskammer (1) aus Oberflächen gebildet wird, die derart miteinander verbunden sind, dass es eine untere Fläche (la), eine obere Fläche (1b) und mindestens eine Seitenfläche (1c) gibt und die dielektrische Platte (4) mindestens einen Teil einer der Flächen (1a, 1b, 1c) bildet, die die Reaktionskammer (1) bilden, bildet.

3. Vorrichtung nach Anspruch 2, **dadurch gekennzeichnet, dass** die dielektrische Platte (4) mindestens einen Teil der oberen Fläche (1b) der Reaktionskammer (1) bildet.

4. Vorrichtung nach einem der vorstehenden Ansprüche, **dadurch gekennzeichnet, dass** die Elektrode (7) in einer Wirkverbindung mit der dielektrischen Platte (4) zum Erzeugen einer elektrischen Entladung durch die dielektrische Platte (4) in den Reaktionsraum (2) zum Erzeugen von Plasma zusammen mit den Precursors, die in den Reaktionsraum (2) geladen werden, angeordnet ist.

5. Vorrichtung nach einem der vorstehenden Ansprüche, **dadurch gekennzeichnet, dass** die dielektrische Platte (4) aus Glas hergestellt ist.

6. Vorrichtung nach einem der vorstehenden Ansprüche, **dadurch gekennzeichnet, dass** die Elektrode (7) außerhalb der Reaktionskammer (1) angeordnet ist.

7. Vorrichtung nach einem der vorstehenden Ansprüche, **dadurch gekennzeichnet, dass** die Vorrichtung ferner mindestens einen Precursor-Zuführkanal (5) zum Laden eines Precursors in den Reaktionsraum (2) und mindestens einen Entladungskanal (6) zum Entladen eines Precursors aus dem Reaktionsraum (2) umfasst.

8. Vorrichtung nach Anspruch 7, **dadurch gekennzeichnet, dass** der mindestens eine Precursor-Zuführkanal (5) und der mindestens eine Entladungskanal (6) an der Seitenfläche (1c) bereitgestellt sind.

## Revendications

1. Appareil pour soumettre une surface d'un substrat à des réactions de surface d'au moins un premier précurseur et d'un second précurseur selon les principes de dépôt de couche atomique, ledit appareil comprenant :
- une chambre de réaction (1) formant un espace de réaction (2) pour recevoir des gaz précurseurs qui réagissent sur la surface du substrat,
- un support de substrat (3) pour maintenir le substrat,
- une plaque diélectrique (4), dans lequel la plaque diélectrique (4) est agencée de façon amovible sur l'appareil de sorte qu'elle puisse être retirée de l'appareil sans démonter l'ensemble de l'appareil, et
- une électrode (7) couplée à une source de tension (8) pour induire une tension dans l'électrode (7) afin de générer une décharge électrique dans l'espace de réaction (2),
- la plaque diélectrique (4) étant agencée entre le support de substrat (3) et l'électrode (7) de sorte que l'espace de réaction (2) soit agencé entre le support de substrat (3) et la plaque diélectrique (4), le support de substrat (3) étant mobile dans une direction verticale afin de déplacer le substrat (1) entre une position de traitement dans laquelle la chambre de réaction (1) se trouve dans un état fermé et une position de chargement dans laquelle la chambre de réaction (1) se trouve dans un état ouvert, **caractérisé en ce que** la plaque diélectrique (4) est mobile conjointement au support de substrat (3) entre la position de traitement et la position de chargement.

2. Appareil selon la revendication 1, **caractérisé en ce que** la chambre de réaction (1) est formée à partir de surfaces raccordées les unes aux autres de sorte qu'il existe une surface de dessous (la), une surface de dessus (1b) et au moins une surface latérale (1c) et que la plaque diélectrique (4) forme au moins une partie de l'une des surfaces (1a, 1b, 1c) formant la chambre de réaction (1).

3. Appareil selon la revendication 2, **caractérisé en ce que** la plaque diélectrique (4) forme au moins une partie de la surface de dessus (1b) de la chambre de réaction (1).

4. Appareil selon une quelconque revendication précédente, **caractérisé en ce que** l'électrode (7) est agencée dans une connexion fonctionnelle avec la plaque diélectrique (4) afin de générer une décharge électrique à travers la plaque diélectrique (4) jusqu'à l'espace de réaction (2) afin de générer un plasma conjointement à des précurseurs fournis dans l'espace de réaction (2).

5. Appareil selon une quelconque revendication précédente, **caractérisé en ce que** la plaque diélectrique (4) est constituée de verre.

6. Appareil selon une quelconque revendication précédente, **caractérisé en ce que** l'électrode (7) est agencée à l'extérieur de la chambre de réaction (1).

7. Appareil selon une quelconque revendication précédente, **caractérisé en ce que** l'appareil comprend en outre au moins un canal d'apport de précurseur (5) afin de fournir un précurseur à l'espace de réaction (2) et au moins un canal d'évacuation (6) afin d'évacuer un précurseur de l'espace de réaction (2).

8. Appareil selon la revendication 7, **caractérisé en ce que** l'au moins un canal d'apport de précurseur (5) et l'au moins un canal d'évacuation (6) sont prévus sur la surface latérale (1c).
